# EUROPÄISCHE PATENTSCHRIFT

(11) **EP 1 041 648 B1**
(45) Veröffentlichungstag und Bekanntmachung des Hinweises auf die Patenterteilung: **07.12.2005**
(21) Anmeldenummer: 00104971.7
(22) Anmeldetag: 09.03.2000
(51) Int. Cl.: H01L 31/18, H01L 27/142

(54) **Verfahren und Verwendung einer Durchtrennungsvorrichtung zur Herstellung eines CdS/CdTe Dünnschichtsolarmoduls**
Method and use of a cutting apparatus for manufacturing a CdS/CdTe thin film solar module
Méthode et utilisation d'un appareil de coupe pour fabriquer un module solaire à couche mince de CdS/CdTe

(30) Priorität: 29.03.1999 EP 99106372
(43) Veröffentlichungstag der Anmeldung: 04.10.2000
(73) Patentinhaber: ANTEC Solar Energy AG, 60311 Frankfurt am Main (DE)
(72) Erfinder: Todisco, Alexandra, 64560 Riedstadt (DE); Bonnet, Dieter Dr., 61382 Friedrichsdorf (DE); Dinges, Peter, 60435 Frankfurt (DE)
(74) Vertreter: Grünberg, Thomas

(56) Entgegenhaltungen:
- DE-A- 2 751 272
- US-A- 3 138 875
- US-A- 4 502 225
- EBONG A U ET AL: "Mechanically grooved, double sided, buried contact silicon solar cells" RENEWABLE ENERGY,GB,PERGAMON PRESS, OXFORD, Bd. 11, Nr. 3, 1. Juli 1997 (1997-07-01), Seiten 331-340, XP004065064 ISSN: 0960-1481
- BONNET D ET AL: "PRODUKTION VON DUENNSCHICHTSOLARZELLEN" ELEKTROTECHNIK UND INFORMATIONSTECHNIK,SPRINGER VERLAG, WIEN,AT, Bd. 115, Nr. 11, 1998, Seiten 608-615, XP000870897 ISSN: 0932-383X
- EBONG A U S ET AL: "Adaptation of drafting plotter for buried contact groove formation" SOLAR ENERGY,GB,PERGAMON PRESS. OXFORD, Bd. 57, Nr. 3, 1. September 1996 (1996-09-01), Seiten 185-193, XP004016241 ISSN: 0038-092X

## Beschreibung

Die Erfindung betrifft ein Verfahren und eine Verwendung einer Durchtrennungsvorrichtung zum Herstellen eines CdS/CdTe Dünnschichtsolarmoduls.

Eine Herstellungsmöglichkeit eines Dünnschichtsolarmoduls mit mehreren auf einem gemeinsamen Substrat parallel angeordneten Solarzellen, die durch mehrere zellenübergreifende Beschichtungsschritte und Schicht-Trennschritte während der Zellenherstellung erzeugt und zusammengeschaltet werden, ist bereits in der US 4 243 432 beschrieben worden. Dort werden CdS-CuₓS- Solarzellen dadurch hergestellt, daß ein Glassubstrat stets vollständig nacheinander mit den einzelnen Schichten versehen wird, nämlich in der Hauptsache einer als untere Elektrode dienenden harten Kontaktschicht aus SnOₓ und einer darüber liegenden pn-Doppelschicht aus CdS-CuₓS sowie einer als obere Elektrode dienenden weiteren Kontaktschicht. Zwischen den einzelnen Beschichtungsschritten soll durch parallele Schnitte dafür gesorgt werden, daß einerseits die Aufteilung der zellenübergreifenden Substratbeschichtung in einzelne Zellen erzielt wird und andererseits die Zellen eines Substrats auch elektrisch hintereinander geschaltet werden. Zur seriellen Zusammenschaltung der Zellen wird durch die Schnittsetzung dafür gesorgt, daß die obere Elektrode einer Zelle 1 die untere Elektrode der folgenden Zelle 2 berührt, hingegen von der oberen Elektrode der Zelle 2 getrennt ist. Dieses Schema wird über die gesamte Substratlänge fortgesetzt. Es werden verschiedene Trennverfahren für die einzelnen Schichten u.a. mit Ultraschalltechnik vorgeschlagen, und es ist ausgeführt, daß die pn-Schicht auch mechanisch beispielsweise mit einem rotierenden oder nicht rotierenden Schneidwerkzeug trennbar ist.

Ein ähnliches Verfahren ist in der US 4 315 096 für CdTe- und CdS-Schichten offenbart, wobei auch hier die Trennschnitte zwischen 5 µm und 100 µm Breite wahlweise mit nicht näher definierten mechanischen Verfahren oder mittels Laserstrahlung erzeugt werden. Auch die US 5 501 744 befaßt sich mit der Herstellung von CdTe- und CdS-Solarzellen.

Die Module sollen dabei mit einem in transversaler und longitudinaler Richtung relativ zum Substrat verfahrbaren Werkzeugkopf bearbeitet werden. Dieser Kopf enthält nebeneinander angeordnete Laser, Sandstrahlgebläse oder auch Beschichtungsvorrichtungen, die schräg auf das Substrat gerichtet sind und vorzugsweise das Substrat nicht berühren. Nach der Bearbeitung des Substrats in Längsrichtung wird der Kopf in transversaler Richtung in eine neue Ausgangsstellung für die longitudinale Bewegung versetzt. Während dieser Transversalbewegung sind die Bearbeitungseinheiten nicht aktiviert.

Die bisher im Handel erhältlichen Silizium-Solarzellenmodule werden allerdings in der Regel immer noch nicht nach dem obigen Verfahren der US 4 243 432, sondern aus einzelnen Zellen aufgebaut, die mit Hilfe von angelöteten Metallbändern verschaltet sind. Module mit CdS-CuₓS- Solarzellen sind bislang nicht nach dem oben aufgezeigten Verfahren der US 4 243 432 industriell hergestellt worden. Das gleiche gilt für die seit geraumer Zeit als erfolgversprechende Kandidaten geltende CdS/CdTe-Solarzellen mit einem an das Glassubstrat angrenzenden Frontkontakt aus einer lichtdurchlässigen TCO-Schicht, zumeist in Form der sogenannten ITO-Schicht. Hinsichtlich Herstellung und Aufbau einer solchen einzelnen Solarzelle wird ausdrücklich auf die EP 0 535 522 verwiesen.

Die Erfinder der vorliegenden Anmeldung standen vor der Aufgabe, ein Verfahren zu entwickeln, mit dem eine rationelle Fertigung von Dünnschichtsolarmodulen unter Ausnutzung einer zellenübergreifenden Beschichtung durch eine schnelle und sichere Trenntechnik möglich ist. Ferner sollte eine geeignete Trennvorrichtung zur Fertigung von Dünnschichtsolarmodulen gefunden werden, die ein derartiges schnelles und dabei sicheres Trennen ermöglicht. Ein schnelles Trennen ist deshalb erforderlich, weil die Trennschritte Teil des Durchlaufprozesses sind und nicht von diesem abgekoppelt werden können. Darüber hinaus muß bei dem Trennvorgang sichergestellt sein, daß die gewünschten Schichten ausreichend vollständig durchtrennt werden, hingegen die darunter liegenden Schichten nicht beschädigt werden.

Die im Anspruch 1 gekennzeichnete Lösung zeichnet sich dadurch aus, daß man für die CdS/CdTe pn-Schicht ein ritzendes stichelförmiges Schneidwerkzeug einsetzt. Entgegen üblichen Schneidvorrichtungen weist das erfindungsgemäß eingesetzte Schneidwerkzeug eine abgeplattete Spitze auf, wobei die durch die Abplattung geschaffene ebene Fläche als Gleitfläche des Werkzeugs dient. Das Werkzeug wird so geführt, daß es mit dieser Gleitfläche während des Trennvorgangs auf der ersten Kontaktschicht gleitet, wobei die Gleitfläche ganzflächig auf dieser zu ihr parallelen Schicht aufliegt. Die Längsachse des Werkzeugs steht dabei senkrecht auf der Kontaktschicht bzw.dem Substrat. Durch diese Bedingungen ist die Gefahr, daß die Kontaktschicht der CdS/CdTe Solarzellen durch die ebene Gleitfläche des Werkzeugs beschädigt wird, minimiert. Die Einstellung der auf das Werkzeug ausgeübten Andruckkraft ist weitestgehend unkritisch. Die Kraft kann hinreichend gefahrlos so hoch eingestellt werden, daß die CdS/CdTe ph-Doppelschicht sicher durchtrennt wird. Es müssen keine aufwendigen Regelungen und Justierungen für die Eindringtiefe des Werkzeugs vorgesehen werden. Darüber hinaus kann das Werkzeug ohne aufwendige Justierung in unterschiedliche Richtungen verfahren werden und so z.B. einer mäanderförmigen Bahn folgen, ohne vor dem Weiterschieben in einen neuen Arbeitsbereich und der Bewegung in einer neuen Bearbeitungsrichtung verdreht zu werden. Mit anderen Worten kann das Werkzeug in variablen, insbesondere auch in entgegengesetzten Bearbeitungsrichtungen über das Substrat verschoben werden, ohne zuvor verdreht zu werden oder zuvor auf eine bestimmte Substratseite zurückgeführt werden zu müssen.

Entgegen der sonst üblichen Technik der Anwendung von nicht rotierenden Schneidwerkzeugen wie Sticheln braucht im erfindungsgemäßen Verfahren das Schneidwerkzeug weder während des Schneidbetriebs noch beim Vorschieben des Werkzeugs in einen neuen Arbeitsbereich vom beschichteten Substrat abgehoben zu werden. Durch ein Vermeiden des Anhebens und des Wiederabsenkens des Werkzeugs auf der Frontkontaktschicht konnten die Standzeit des Schneidwerkzeugs erhöht werden und die Rationalität des Verfahrens gesteigert werden.

Bei den bekannten Ritzwerkzeugen, die in Schrägstellung und ohne parallele Gleitfläche über ein Substrat gezogen werden, treffen die genannten Vorteile nicht zu. Die US 4 502 225 benutzt ein Ritzwerkzeug, das unter einem schrägen Winkel zur Horizontalen von bevorzugt 75° über ein Substrat bewegt wird, um Siliziumschichten zu trennen. Das Werkzeug weist vorzugsweise eine abgedrundete Diamantspitze auf. Als Alternativen des schräg stehenden Werkzeugs sind pyramiden- oder kegelstumpfartige Spitzen erwähnt. Gemäß dieses US-Patents sind die Druckeinstellung des Werkzeugs und dessen scharfe Ritzspitze mit einem bevorzugten Durchmesser von etwa 0,01 mm sehr kritisch. Um eine definierte Eindringtiefe des in der Spitze abgerundeten schräggestellten Werkzeugs in die zu trennende Schicht zu erzielen und die darunter liegende Schicht nicht zu beschädigen, wird die Andruckkraft mit hohem mechanischen Aufwand in engen Grenzen eingestellt. Es wird versucht, über Widerstandsmessungen eine erfolgreiche Schichtdurchtrennung nachzuvollziehen, - eine Maßnahme die im Falle nicht leitender Schichten ausscheidet. Nach Durchtrennen eines Schichtsegments über die Substratlänge wird das Werkzeug angehoben und in die neue Ritzstellung verfahren, in der es wieder abgesenkt wird. Das gezeigte Ritzwerkzeug kann nur in einer Bearbeitungsrichtung verfahren werden.

Die US 4 589 194 zeigt ebenfalls einen schräg zur Substratoberfläche geführten Ritzstift, der alternativ zur bevorzugten diamantenen Spitze wahlweise auch insgesamt aus einem Hartmetall hergestellt ist. Es werden amorphe Siliziumschichten und darüber liegende Rückkontaktschichten durchtrennt. Um die darunter liegende TCO-Schicht mit dem spitzen Werkzeugende von nur etwa 0,006 mm Durchmesser maximal und den offenbarten relativ hohen Andruckkräften nicht zu verletzen, wird die Si-Schicht nicht völlig durchtrennt, sondern soweit, daß noch etwas von der Si-Schicht über der TCO-Schicht stehen bleibt. Der Ritzstift muß folglich empfindlich justiert werden. Die Ritzstiftspitze wird in Ultraschallschwingung versetzt. Zum Verschieben in eine neue Ritzstellung wird der schräg stehende Ritzstift vom Substrat abgehoben.

In den Dokumenten EBONG A U et al: "Mechanically grooved, double sided, buried contact silicon solar cells" RENEWABLE ENERGY, GB, PERGAMON PRESS, Oxford, Bd. 11, Nr.3, 1.Juli 1997, Seiten 331-340, XP004065064 ISSN:0960-1481, und EBONG A U et al: "Adaption of drafting plotter for buried contact groove formation", SOLAR ENERGY, GB, PERGAMON PRESS, Oxford, Bd. 57, Nr.3, 1.September 1996, Seiten 185-193, XP004016241 ISSN:0038-092X, wird ein senkrecht zu einem Si-Substrat geführtes Ritzwerkzeug mit scharfer Spitze dazu benutzt, tiefe weit in das harte Si-Substrat hinein reichende Nuten für sogenannte "buried contacts" mit sehr geringen Breiten hinein zu ritzen, wie sie sonst mit Lasern erzielbar sind. Auf die Problematik gegenüber einer Schrägstellung des Ritzwerkzeugs hinsichtlich Waferbeschädigung und geringer Ausbeute wird eingegangen.

Gegenüber den schräg über die beschichteten Substrate zu ziehenden Ritzwerkzeugen sind die Justiermaßnahmen am erfindungsgemäßen stichelförmigen Werkzeug mit der zum Substrat parallelen Gleitfläche erheblich geringer. Der Stichel kann ferner, ohne angehoben zu werden, mit hoher Geschwindigkeit mit präziser und stabiler Bewegung in verschiedene Richtungen verfahren werden. Das erfindungsgemäße Werkzeug wird senkrecht stehend über das beschichtete Substrat geführt und gleitet mit der zu seiner Längsachse senkrecht stehenden Gleitfläche sicher und schonend auf der härteren Kontaktschicht und durchtrennt die darüber liegende Schicht zuverlässig und vollständig.

Ein Verfahren zum Herstellen eines CdS/CdTe Dünnschichtsolarmoduls ist in Anspruch 1 definiert.

Eine Verwendung einer Durchtrennungsvorrichtung zum Herstellen eines CdS/CdTe Dünnschichtsolarmoduls ist in Anspruch 11 definiert.

Bevorzugte Weiterbildungen der Erfindung sind in den Unteransprüchen gekennzeichnet.

Das erfindungsgemäße Verfahren eignet sich besonders gut für die genannten CdS/CdTe-Solarzellen mit einem Frontkontakt aus einer harten und glatten TCO-Schicht wie der ITO-Schicht, die um etwa den Faktor zehn härter ist als die weiche, spröde pn-Schicht. Auf diese Weise ist es möglich, die pn-Schicht zu durchtrennen, ohne in das Frontkontaktmaterial einzudringen, auf dem das Schneidwerkzeug beim Durchtrennen der pn-Schicht mit seiner abgeplatteten Spitze gleitet. Das Verfahren ist dadurch besonders rationell gestaltbar, daß das Schneidwerkzeug vor dem Weiterschieben zu einer neuen Ausgangsposition nicht abgehoben zu werden braucht, sondern lediglich in einer anderen zweiten Vorschubrichtung weitergeschoben wird, bevor es in eine nun geänderte, im allgemeinen entgegengesetzte Bearbeitungsrichtung weiterbewegt wird. Mit Schneidwerkzeugen mit rotierendem Schneidkopf oder periodisch vom Substrat abzuhebenden und wieder abzusenkenden Schneidwerkzeugen ist dieser Vorteil im Hinblick auf ein rationelles Verfahren nicht erzielbar. Dies gilt auch für die erläuterten schräg geführten Ritzwerkzeuge.

Anwender, die eine Verschiebung des Werkzeugs im Randbereich der Module in der zweiten Vorschubrichtung ohne Werkzeuganhebung nicht wünschen, können selbstverständlich die Verlängerung des Prozesses durch Anheben und Wiederabsenken des Werkzeugs in Kauf nehmen. Ordnet man genügend viele Werkzeuge parallel nebeneinander an, um den ganzen Modul in einem Arbeitsgang zu bearbeiten, entfallen das An- und Abheben während der Modulbeschichtung ohnehin.

Da vorzugsweise das gesamte Substrat mit der pn-Schicht versehen wird, durchtrennt das Schneidwerkzeug beim Weiterschieben ebenfalls die pn-Schicht und gleitet auf der Frontkontaktschicht. Das Verfahren deckt jedoch auch den Fall ab, daß das Schneidwerkzeug in der zweiten Vorschubrichtung in einem pn-schichtfreien Bereich des Substrats auf der Frontkontaktschicht weitergeschoben wird.

Beim Weiterschieben in der zweiten Vorschubrichtung wird nicht die erste Schneidkante des Schneidwerkzeugs benutzt, sondern eine andere Werkzeugseite in die zweite Vorschubrichtung bewegt. Das vorzugsweise mit rechteckiger Gleitfläche versehene Schneidwerkzeug wird nach dem Weiterschieben, vorzugsweise wieder ohne abzuheben und ohne um seine Längsachse gedreht zu werden, entgegengesetzt zur ersten Vorschubrichtung bewegt.

Von konstruktivem Vorteil ist es, die Relativbewegung in der ersten Vorschubrichtung, in der die pn-Schicht durchtrennt wird, nur durch Bewegen des oder der Schneidwerkzeuge zu bewerkstelligen.

Vorzugsweise wird das Schneidwerkzeug mit seiner Gleitfläche federnd gegen das beschichtete Substrat gedrückt. Sonst in der Werkstückbearbeitungstechnik aufwendige Justierungsmaßnahmen von fest eingespannten Schneidwerkzeugen entfallen. Mit dem federnd gegen die Frontkontaktschicht gedrückten erfindungsgemäßen Schneidwerkzeug wird stets die pn-Schicht zuverlässig durchtrennt.

Das Verfahren konnte durch weitere Optimierung der Standzeit des Schneidwerkzeugs noch mehr rationalisiert werden, weil zu Beginn des Schneidwerkzeugeinsatzes mit einem Werkzeug gearbeitet wird, dessen Spitzenabplattung einen geringst möglichen Wert hat, der durch Abrieb während der Einsatzdauer zunimmt. Im Verfahren wird die Einsatzdauer so begrenzt, daß diese Abplattung in einem tolerierbaren Bereich liegt, in dem das Werkzeug noch ausreichend durchtrennt. Demgegenüber wird zu Anfang mit einer geringen Spitzenabplattung gearbeitet, bei der die Werkzeugspitze, ohne die erste Kontaktschicht zu beschädigen, auf dieser gleitet. Hierbei spielt auch die Andruckkraft des Werkzeugs unter Einbeziehung der eingestellten Federwirkung eine Rolle. Vorzugsweise wird die Andruckkraft mit abriebbedingter Flächenzunahme der abgeplatteten Spitze vergrößert, um stets einen gleichen optimalen Druck zu erzeugen. Die durch die Feder ausgeübte Kraft wird so eingestellt, daß einerseits die erste Kontaktschicht nicht beschädigt wird und andererseits ein Aufgleiten des Werkzeugs verhindert wird. In der Fertigungsanlage wurde die Andruckkraft der erfindungsgemäßen Werkzeuge bei ununterbrochener Einsatzdauer des Werkzeugs von einer Wochen nur zweimal nachgestellt.

Die im Anspruch 11 verwandete Durchtrennungsvorrichtung ist ein einfach und kostengünstig herzustellendes Schneidwerkzeug. Mit diesen Eigenschaften eignet sich das auszuwechselnde Werkzeug für die angestrebte Massenproduktion von Dünnschichtsolarmodulen.

So wurde gefunden, daß sich besonders große Durchtrennungsstrecken bis zu 20 km mit rechteckiger Gleitfläche und vorzugsweise ungleich langen Schneidkanten erzielen ließen, ohne daß das Werkzeug ausgetauscht und der Herstellungsprozeß unterbrochen werden mußten. Vorzugsweise wird ferner mit einer Spitze nach Art eines umgekehrten vierseitigen, geraden Pyramidenstumpfes als Werkzeugspitze gearbeitet, mit dem die erste Vorschubrichtung oder Hauptritzrichtung unter gleichen Durchtrennungsbedingungen umkehrbar ist.

Auch wurde gefunden, daß sich mit den ungleich langen Schneidkanten in Hauptritzrichtung und der vorzugsweise hierzu rechtwinkligen Verschiebungsrichtung ein optimales Verhältnis von auf das Schneidwerkzeug aufzubringender Kraft und Flächenpressung erzielen läßt. Ein solches erfindungsgemäßes Schneidwerkzeug bietet zudem den Vorteil, daß es auch noch bei einem leichten Schräglauf zufriedenstellende Schnitte ausführt, wobei zusätzlich zur Schneidkante in Hauptritzrichtung die Schneidkante in der Verschiebungsrichtung zum Tragen kommt. Hierdurch ist es möglich, auch ohne aufwendige Nachjustierungen der relativen Winkelausrichtung von Substrat und Werkzeug parallele Schnitte auf dem Substrat zu gewährleisten.

Die Justierung, Halterung und Bewegung des senkrecht auf dem Substrat stehenden Werkzeugs sind mit geringem mechanischen Aufwand zu realisieren.

Bei einer CdS/CdTe pn-Doppelschicht, in der die CdS-Schicht eine Dicke im Bereich von nur 100 nm oder weniger aufweist, haftet diese dünne CdS-Schicht so stark auf der ersten Kontaktschicht, daß sie von dem Schneidwerkzeug nicht abgetragen wird. Da die CdS-Schicht jedoch derart dünn ist, zeigt sie praktisch die Härte der darunter liegenden harten ersten Kontaktschicht. Für die abgeplattete Werzeugspitze ergeben sich somit gleiche Gleitbedingungen. Bei dickeren CdS-Schichten kommt deren Sprödigkeit immer mehr zum Tragen, so daß sie dann zusammen mit der CdTe-Schicht abgetragen werden.

Im folgenden wird die Erfindung anhand der Zeichnungen näher erläutert. Es zeigen:
Figur 1 eine schematische Darstellung eines Dünnschichtsolarmoduls mit von leitfähigem Material befreitem Randbereich von oben;
Figur 2 eine Querschnittsansicht durch einen Teil des Moduls nach Figur 1;
Figur 3 eine Seitenansicht eines bevorzugten Ausführungsbeispiels eines erfindungsgemäßen stichelförmigen Schneidwerkzeugs;
Figur 4 eine Seitenansicht des Schneidwerkzeugs in Richtung des Pfeils der Figur 3;
Figur 5 eine gegenüber Figur 3 vergrößerte Darstellung der Schneidwerkzeugspitze;
Figur 6 eine gegenüber Figur 4 vergrößerte Darstellung der Schneidwerkzeugspitze;
Figur 7 ist eine wiederum gegenüber Figur 4 vergrößerte Ansicht der Schneidwerkzeugspitze von unten;
Figur 8 eine gegenüber Figur 7 vergrößerte Teilansicht der Schneidwerkzeugspitze;
Figur 9 eine schematische perspektivische Ansicht vom unteren Ende der Schneiwerkzeugspitze; und
Figur 10 eine schematische Seitenansicht eines Werkzeughalters mit mehreren darin aufgenommenen Schneidwerkzeugen in Arbeitsstellung über einem auf einem Tisch angeordneten Modulsubstrat.

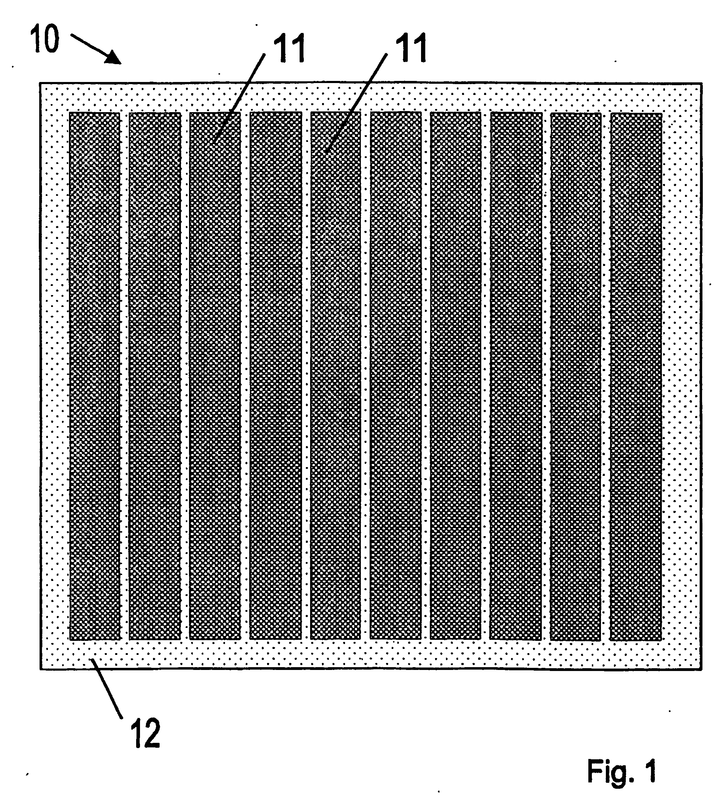

Das Dünnschichtsolarmodul 10 der Figur 1 zeigt zehn auf einem Glassubstrat 12 parallel nebeneinander angeordnete Solarzellen 11 nach dem Durchtrennen der CdS/CdTe-Schicht vor dem Aufbringen der Rückkontaktbeschichtung. Ein typisches Modul hat etwa 100 individuelle Zellen pro Meter seiner Länge. Es sind daher zur Strukturierung des Moduls eine Vielzahl von Schnitten über große Schnittlängen auszuführen.

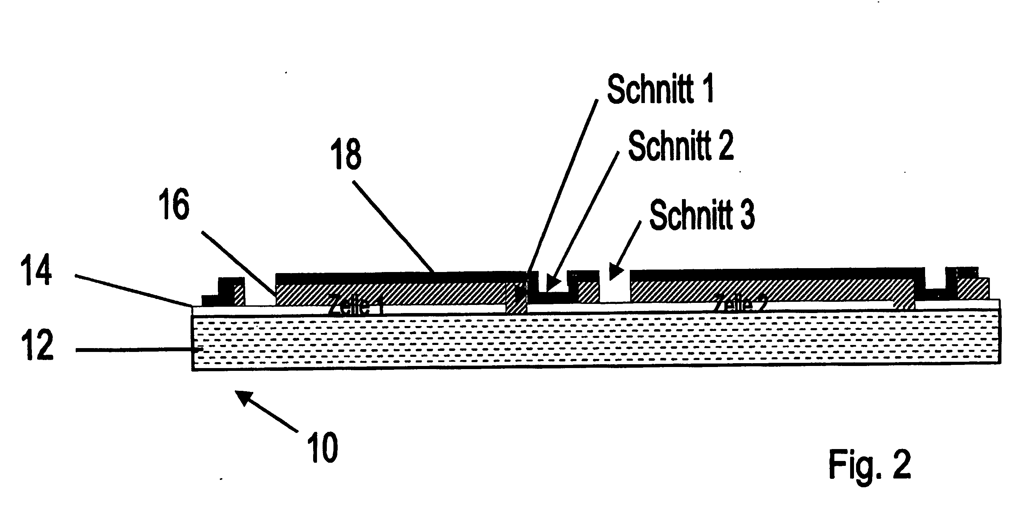

Die Schnittansicht der Figur 2 zeigt das Substrat 12 mit aufgebrachtem Rückkontakt 18. Auf dem Glassubstrat 12 aus vorzugsweise Fensterglas liegt eine TCO-Schicht 14, die mit einem Schnitt 1 zellenweise unterbrochen ist. Dieser Schnitt von im Ausführungsbeispiel etwa 100 µm Breite wird mit einem Laser, beispielsweise einem Neodym-YAG-Laser, nach Aufbringen der TCO-Schicht durch Ablation erzeugt. Dieser erste Schnitt bestimmt die Breite der in Serie zu verschaltenden Zellen.

Nach Aufbringen der pn-Doppelschicht 16 vorzugsweise durch CdS-Abscheidung und darauffolgende CdTe-Abscheidung und Aktivierung dieser Schicht wird das abgekühlte Modul einem Schnitt 2 unterzogen, bei dem es sich um einen ersten mechanischen Trennschnitt mit dem erfindungsgemäßen Schneidwerkzeug handelt. Der Schnitt 2 durchtrennt die pn-Schicht 16 nahe dem ersten Schnitt 1 bis zur TCO-Schicht 14. Die Breite des Schnitts beträgt im Ausführungsbeispiel zu Anfang etwa 0,06mm.

Bei einer CdS/CdTe pn-Doppelschicht, in der die CdS-Schicht im Vergleich zur etwa 3 bis 7 µm dicken CdTe-Schicht eine Dicke im Bereich von nur 100 nm oder weniger aufweist, wird die CdS-Schicht, wie weiter oben dargelegt, nicht abgetragen. Die Funktion der seriellen Verschaltung wird durch den Verbleib der CdS-Schicht nur unwesentlich beeinflußt.

Anschließend wird der Rückkontakt 18 (bevorzugt eine Doppelschicht aus einer Halbleiterschicht, z.B. Tellur, und einer Metallschicht, z.B. Nickel) aufgedampft. Anschließend erfolgt Schnitt 3 wiederum mit dem erfindungsgemäßen Schneidwerkzeug unter gleichzeitiger Durchtrennung des Rückkontakts 18 und der pn-Schicht 16.

Die Schnitte 1 bis 3 verlaufen in Längsrichtung der streifenförmigen Zellen 11 gemäß Darstellung in Figur 1. Das Werkzeug wird nach Ausführung eines solchen Längsschnitts vorzugsweise im noch beschichteten Substratrandbereich quer zur Längsrichtung der Zellen 11, ohne abzuheben und um seine Längsachse verdreht zu werden, verschoben. Anschließend wird der nächste Längsschnitt mit zum vorhergehenden Längsschnitt entgegengesetzter Vorschubrichtung des Werkzeugs vorgenommen. Das Werkzeug wird somit mäander- oder rechteckwellenförmig relativ zum Substrat bewegt. Mit dem erfindungsgemäßen Werkzeug können ohne weiteres Schnittgeschwindigkeiten von 30m/min realisiert werden. Für die Produktion wird bei Einsatz mehrerer parallel schneidender Schneidwerkzeuge bei den vorgegebenen Modulen mit einer Geschwindigkeit von etwa 10m/min gearbeitet.

Während des Schneidvorgangs werden die Schneidabfälle abgesaugt. Eine Reinigung des beschichteten Substrats vor dem nächsten Beschichtungsschritt ist nicht erforderlich.

Wie weiter oben erläutert, wird die Hintereinanderschaltung der Zellen dadurch erzielt, daß der Rückkontakt der Zelle 1 mit dem Frontkontakt, d.h. der TCO-Schicht 14 der Zelle 2 verbunden ist, usw.

Prinzipiell können die Zellen unter Verwendung der hier beschriebenen Trenntechnik auch anders verschaltet werden.

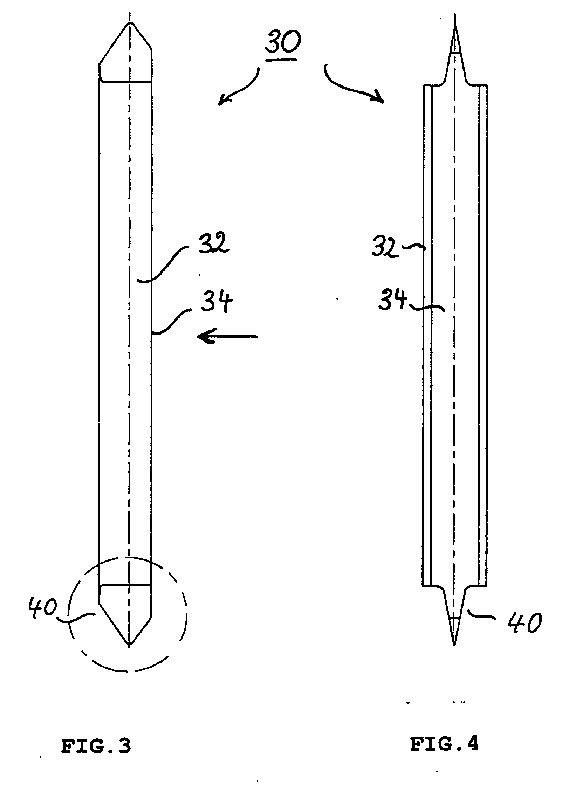

Das in den Figuren 3 bis 7 gezeigte stichelförmige Schneidwerkzeug 30 weist eine Spitze 40 in Form eines umgekehrten Kegelstumpfes auf. Gemäß der bevorzugten Ausführung wird in der Zeichnung eine vierseitige gerade Pyramide mit zwei unterschiedlich langen Grundkanten 42 und 44 der unteren Grundfläche 41 des Stumpfes zugrunde gelegt. Diese Grundkanten bilden eine erste und zweite Schneidkante des Werkzeugs. Die sich von der ersten und zweiten Schneid- oder Grundkante 42, 44 erstreckenden Seitenflächen des Pyramidenstumpfes, die die Spanflächen des Schneidwerkzeugs bilden, weisen unterschiedlich große Öffnungswinkel α und β auf. Der erste kleinere Winkel α definiert die Spanfläche 46 in einer ersten Haupt-Ritzrichtung des Werkzeugs 30 und der zweite größere Winkel β definiert die größere Spanfläche 48 in einer zweiten Ritzrichtung zur Verschiebung des Werkzeugs 30. Der erste Winkel α bestimmt die Schnittbreite des Werkzeugs, die im Verlaufe der abriebbedingten Abnutzung bis zu einem tolerierbaren Wert zunimmt.

Im Ausführungsbeispiel betragen die Winkel α = 20° und β = 70°. Die kürzere Schneid-oder Grundkante 42 der rechteckigen Gleitfläche 41, die der Grundfläche des Pyramidenstumpfes entspricht, hat im Ausführungsbeispiel eine ursprüngliche Breite von etwa 0,06 mm. Die längere Grundkante ist entsprechend der gewählten Winkel 0,24 mm breit. Im Ausführungsbespiel beträgt die durch die Modulauslegung vorgegebene maximale Schnittbreite etwa 0,1 mm. Die zugehörige Spanfläche 46 schließt im Ausführungsbeispiel im Einsatz des Werkzeugs 30 mit der beschichteten Substratebene bzw. der verlängerten Gleitfläche 41 einen Winkel von γ= 55° ein, der in der Hauptritzrichtung oder Zellenlängsrichtung zur Wirkung kommt. Dagegen schließt die größere Spanfläche 48 mit der Substratebene einen Winkel von 80° ein, der in Zellenquerrichtung, d.h. der Verschiebungsrichtung für das Werkzeug zur Wirkung kommt. In dieser Richtung sind Trennwirkung und Schnittbreite des Werkzeugs in der pn-Doppelschicht bei diesem Ausführungsbeispiel nicht von Bedeutung, da der Randbereich des Substrats nach Aufbringen des Rückkontakts 18 bei der Fertigstellung des Moduls völlig entschichtet wird. Bei dieser Entschichtung werden die Strukturen beseitigt, die bei der Bewegung des Werkzeugs in Verschiebungsrichtung in den Substratschichten hervorgerufen wurden.

Die oben angegebenen Werte der Gleitfläche kann der Fachmann variieren, wenn er z.B. breitere Trennstreifen entschichten will. Dies gilt auch für die Winkel. Grundsätzlich wird jedoch beim vorliegenden Ausführungsbeispiel nicht mit einer anfänglichen Breite der Grundkante 42 von weniger als 0,02 µm gearbeitet.

Der Pyramidenstumpf 40 geht in einen zylinderförmigen Schaft 32 über, der in der dargestellten Weise einseitig mit einer ebenen Führungsfläche 34 versehen ist.

Ferner ist in der gezeigten Ausführung das Werkzeug 30 beidseitig mit einer abgeplatteten Spitze 40 versehen, so daß nach Abnutzung einer Spitze die andere Spitze eingesetzt werden kann. Aufgrund der symmetrischen Ausbildung steht die Werkzeuglängsachse bzw. die Längsachse der Werkzeugspitze senkrecht zur Gleitfläche 41.

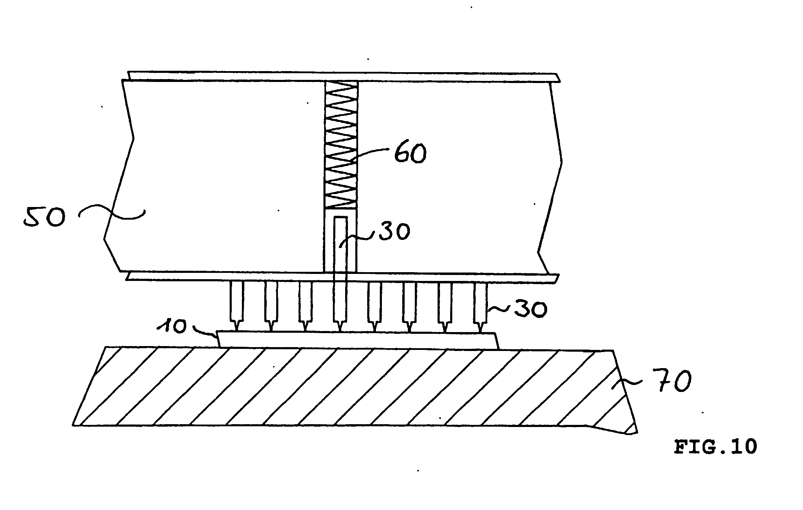

Die Figur 10 zeigt einen Werkzeughalter 50, in dem mehrere der Werkzeuge 30 aufgenommen sind. Für die Fertigungsanlage wurden zwanzig Werkzeuge auf einer Länge von 20 cm angeordnet. Die Werkzeuge bearbeiten gleichzeitig mehrere nebeneinander liegende Zellen auf einem Substrat 10, das auf einem Tisch 70 fixiert ist. Der Tisch definiert die X-Y-Ebene für die Relativbewegung Substrat/Werkzeug. Jedes einzelne Werkzeug 30 ist senkrecht zu seiner Gleitfläche 41 von einer Feder 60 beaufschlagt. Die Werkzeuge 30 sind mittels ihrer Führungsfläche 34 im Werkzeughalter jeweils in einer Pinole unverdrehbar gehaltert. Die Pinole ist in Längsrichtung verschieblich geführt. Die Werkzeuge werden federnd gegen das Substrat 10 gedrückt.

Die Federkraft wird so eingestellt, daß das Werkzeug beim Anfahren die voneinander zu trennenden Schichten durchbricht und im Verlaufe der durchtrennenden Bewegung ständig auf der Kontaktschicht 40 gleitet. Wie weiter oben dargelegt, wird die Federkraft vorzugsweise mit Zunahme der Größe der Gleitfläche erhöht, um einen angenähert gleichen Andruck zu gewährleisten. Für die Materialien und Geometrien des Ausführungsbeispiels wurde ein möglicher Druckbereich von einigen hundert N/mm² bis etwa 1000 N/mm² ermittelt. Auf die von der Firma Federtechnik Knörzer, Pfulllingen, bezogenen Federn unterschiedlicher Federkonstanten im Bereich von 1 bis 10 wurden durch Absenken des Werkzeughalters in Z-Richtung variierende Kräfte ausgeübt. Dadurch wurde die Andruckkraft der Werkzeugspitze auf das Substrat vorzugsweise so eingestellt, daß der Druck 500 N/mm² betrug. Die ausgeübte Kraft wurde während einer einwöchigen Einsatzdauer der Werkzeuge 30 zur Berücksichtigung der Flächenabnutzung um etwa vier bis acht Newton nachgestellt.

Im Ausführungsbeispiel wird der Werkzeughalter 50 durch nicht dargestellte Mittel in Zellenlängsrichtung verfahren und zwischen den in entgegengesetzten Richtungen vorgenommenen Verfahrschritten wird der Tisch quer zur Zellenlängsrichtung um die Anzahl der mit den Werkzeugen bearbeiteten Zellen verschoben.

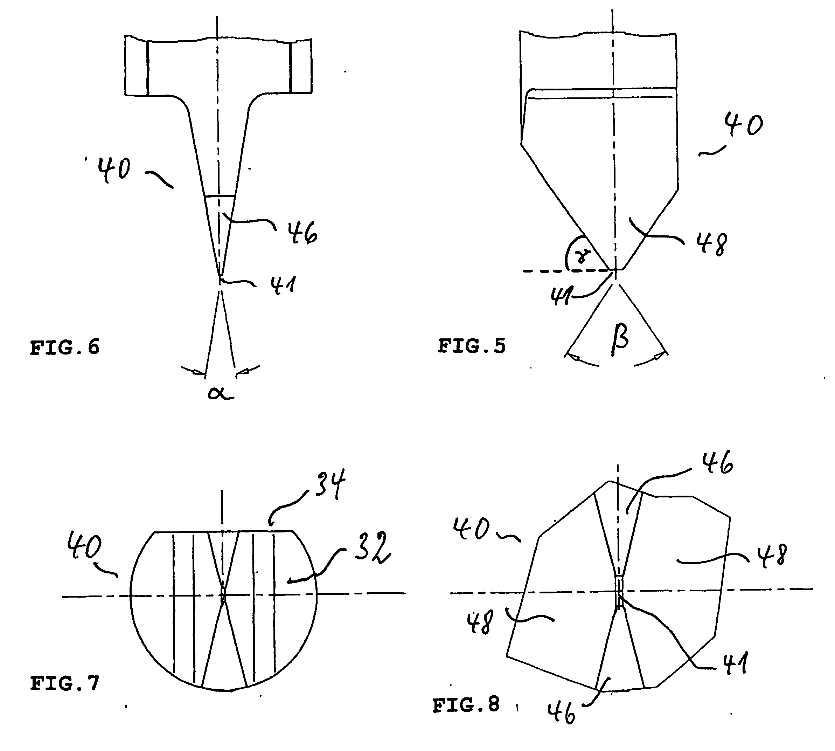

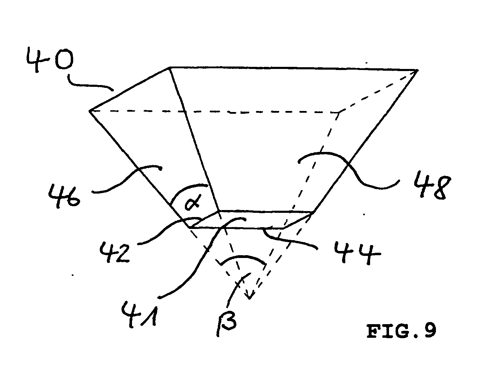

Es sei darauf hingewiesen, daß man das Schneidwerkzeug auch ohne die dargelegten zwei Vorschubrichtungen betreiben kann. So könnte man prinzipiell ausreichend viele Schneidwerkzeuge für sämtliche Zellen eines Substrats in einem Halter nebeneinander anordnen, so daß mit einem einzigen synchronen Längsschnitt die Strukturierung jeder Schicht erzielbar ist. Speziell in diesem Fall könnte man beispielsweise auch eine Spitze in Form eines dreiseitigen Pyramidenstumpfes im erfindungsgemäßen Schneidwerkzeug verwenden. Prinzipiell brauchte die Werkzeugspitze bei einer solchen Ausführung nur eine einzige Schneidkante, so daß die abgeplattete Werkzeugspitze auch halbrund sein könnte. In solchen geometrischen Ausbildungen der Werkzeugspitze ist es ebenfalls von Vorteil, wenn der Winkel zwischen der sich über der Schneidkante erstrekkenden Spanfläche (entsprechend Fläche 46 in Figur 9) und der Verlängerung der abgeplatteten Grundfläche 41 der Werkzeugspitze (bzw. der Schnittfläche) entsprechend dem Winkel γ in Figur 5 zwischen 40°und 90° liegt.

Statt des erläuterten Pyramidenstumpfes bietet ein umgekehrter Kegelstumpf eine weitere mögliche Ausgestaltung der Spitze des erfindungsgemäßen Werkzeugs. Eine solche Form wird bevorzugt zum Herstellen gekrümmter, beispielsweise kreisförmiger Schnittstrukturen eingesetzt.

Bei der pyramidenstumpfartigen Ausbildung nimmt die abriebbedingte Zunahme der Gleitflächenbreite in Hauptritzrichtung mit kleineren Werten von α ab. Damit kann zwar die Standzeit des Werkzeugs gesteigert werden, gleichzeitig ist jedoch die Stabilität des Werkzeugs geringer, die man durch Vergrößern von β nur in gewissem Ausmaß steigern kann. Bei einem bevorzugten Bereich von α zwischen 15° und 40° haben sich für β Werte im Bereich von 100° bis 50° als zweckmäßig erwiesen, die bei Voraussetzung eines vorgegebenen Schneidkantenverhältnisses und geometrisch exakten Pyramidenstumpfes aus den Werten von α berechnet werden können. Der Fachmann wird je nach zu durchtrennendem Material und der Härte der Frontkontaktschicht im Hinblick auf eine möglichst hohe Schneidgeschwindigkeit und Standzeit des Werkzeugs Werte ermitteln, die für seine Anforderungen den bestmöglichen Kompromiß darstellen.

Dabei muß er nicht, wie im bevorzugten Ausführungsbeispiel, einen geometrisch exakten geraden, vierseitigen Pyramidenstumpf voraussetzen, sondern kann auch solche Öffnungswinkel miteinander kombinieren, bei denen die Verlängerungen der Spanflächen nicht in einer gemeinsamen Spitze zusammentreffen. Eine leichtere reproduzierbare Fertigung ergibt sich allerdings bei einem geometrisch exakten Pyramidenstumpf. Auch lassen sich hier infolge des konstanten Schneidkantenverhältnisses die abriebbedingte Flächenzunahme und die Andruckkraftanpassung leichter berechnen.

Die im Ausführungsbeispiel nicht gleichseitige rechteckige Gleitfläche kann auch durch eine quadratische ersetzt werden. Dies ist dann von Vorteil, wenn nicht nur Längsschnitte sondern auch quer verlaufende Schnitte gleicher Breite in einer pn-Schicht erzeugt werden sollen.

Im Ausführungsbeispiel besteht das Schneidwerkzeug aus Widia-Stahl (Typ THM-U der Firma Widia, Essen). Außer anderen Hartmetallen würde sich prinzipiell auch eine diamantene abgeplattete Werkzeugspitze eignen.

## Patentansprüche

1. Verfahren zum Herstellen eines CdS/CdTe Dünnschichtsolarmoduls (10) mit mehreren auf einem gemeinsamen Substrat (12) nebeneinander angeordneten CdS/CdTe- Solarzellen (11), die durch Anwendung mehrerer Beschichtungsschritte und Schicht-Trennschritte während der Zellenherstellung erzeugt und zusammengeschaltet werden, wobei nach Aufbringen einer ersten Kontaktschicht (14) auf dem Substrat (12) und deren zellenweisem Auftrennen eine auf der durchtrennten Kontaktschicht aufgebrachte pn-Doppelschicht (16) aus CdS/CdTe mechanisch durchtrennt wird,
**dadurch gekennzeichnet,**
**daß** die Durchtrennung mit einem stichelförmigen Schneidwerkzeug (30) erfolgt, das durch eine Relativbewegung zum beschichteten Substrat die Zellenstruktur in die pn-Doppelschicht ritzt und dabei mit einer abgeplatteten Spitze (40) auf der ersten Kontaktschicht (14) gleitet, die eine höhere Härte als die pn-Doppelschicht (16) aufweist, wobei das Schneidwerkzeug (30) so geführt wird, daß die durch die Abplattung geschaffene Gleitfläche (41) ganzflächig auf der zu ihr parallelen ersten Kontaktschicht (14) aufliegt.

2. Verfahren nach Anspruch 1,
**dadurch gekennzeichnet,**
**daß** eine auf das Schneidwerkzeug (30) ausgeübte Andruckkraft mit abriebbedingter Flächenzunahme der abgeplatteten Fläche vergrößert wird.

3. Verfahren nach Anspruch 1 oder 2,
**dadurch gekennzeichnet,**
**daß** das Schneidwerkzeug (30), ohne verdreht zu werden und vorzugsweise auch ohne angehoben zu werden, in unterschiedlichen Richtungen relativ zum beschichteten Substrat (12) verfahren wird, um neue Ausgangspositionen zu erreichen und Durchtrennungen in unterschiedlichen Richtungen auszuführen.

4. Verfahren nach einem der Ansprüche 1 bis 3,
**dadurch gekennzeichnet,**
**daß** nach Aufbringen einer zweiten Kontaktschicht (18) auf die CdS/CdTe pn-Doppelschicht (16) diese zweite Kontaktschicht ebenfalls mittels des stichelförmigen Schneidwerkzeugs (30), zusammen mit der darunterliegenden pn-Doppelschicht (16) durchtrennt wird, wobei die abgeplattete Schneidwerkzeugspitze (40) auf der ersten Kontaktschicht (14) gleitet.

5. Verfahren nach einem der vorhergehenden Ansprüche,
**dadurch gekennzeichnet,**
**daß** die pn-Doppelschicht (16) mit einer ersten Schneidkante (42) des Schneidwerkzeugs (30) in einer ersten Vorschubrichtung durchtrennt wird und daß das Schneidwerkzeug in einer zweiten Vorschubrichtung auf dem Substrat weitergeschoben wird.

6. Verfahren nach Anspruch 5,
**dadurch gekennzeichnet,**
**daß** eine mehrere nebeneinander angeordnete Zellen (11) umfassende Zellengruppe durch mehrere gemeinsam in der ersten Vorschubrichtung geführte Schneidwerkzeuge (30) synchron geritzt wird, die anschließend zu einer noch nicht geritzten Zellengruppe in der zweiten Vorschubrichtung, vorzugsweise senkrecht zur ersten Vorschubrichtung, weitergeschoben werden.

7. Verfahren nach Anspruch 5 oder 6,
**dadurch gekennzeichnet,**
**daß** die Relativbewegung in der ersten Vorschubrichtung durch Bewegen des Schneidwerkzeugs (30) und in der zweiten Vorschubrichtung durch Bewegen des Substrats (10) bewerkstelligt wird.

8. Verfahren nach einem der vorhergehenden Ansprüche,
**dadurch gekennzeichnet,**
**daß** das Schneidwerkzeug (30) mit seiner abgeplatteten Spitze (40) federnd gegen die beschichtete Substratfläche gedrückt wird.

9. Verfahren nach einem der vorhergehenden Ansprüche,
**dadurch gekennzeichnet,**
**daß** das Schneidwerkzeug (30) mit anfangs minimal zulässiger Breite seiner Schneidkante (42) solange eingesetzt wird, bis durch abriebbedingte Zunahme der Breite eine maximal zulässige Breite erreicht wird.

10. Verfahren nach einem der vorhergehenden Ansprüche,
**dadurch gekennzeichnet,**
**daß** bei einer CdS/CdTe pn-Doppelschicht, in der die CdS-Schicht eine Dicke im Bereich von nur 100 nm oder weniger aufweist, die abgeplattete Spitze (40) des Schneidwerkzeugs (30) statt auf der ersten Kontaktschicht (14) auf der mit der dünnen CdS-Schicht behaftenen ersten Kontaktschicht gleitet.

11. Verwendung einer Durchtrennungsvorrichtung zum Herstellen eines CdS/CdTe Dünnschichtsolarmoduls (10) mit mehreren auf einem gemeinsamen Substrat (12) nebeneinander angeordneten CdS/CdTe Solarzellen (11), die durch Anwendung mehrerer Beschichtungsschritte und Schicht-Trennschritte mit der Durchtrennungsvorrichtung während der Zellenherstellung erzeugt werden und zusammengeschaltet werden,
**gekennzeichnet durch** mindestens ein stichelförmiges Schneidwerkzeug (30) mit einer abgeplatteten Spitze (40), deren Abplattung eine ebene Gleitfläche des stichelartigen Werkzeugs hat, vorzugsweise in Form nach Art eines umgekehrten Pyramidenstumpfes, dessen kleinere Grundfläche (41) diese Gleitfläche bildet, mit welcher Gleitfläche das Schneidwerkzeug (30) bei einer Relativbewegung zum beschichteten Substrat unter gleichzeitiger Ritzung einer Zellenstruktur in die CdS/CdTe pn-Doppelschicht des Dünnschichtsolarmoduls auf einer unter der Doppelschicht liegenden harten Kontaktschicht (14) gleitet, die eine höhere Härte als die pn-Doppelschicht (16) aufweist, wobei das Schneidwerkzeug (30) in einer Halterungsvorrichtung (50) der Durchtrennungsvorrichtung so geführt ist, daß die ebene Gleitfläche (41) ganzflächig auf der zu ihr parallelen harten Kontaktschicht (14) aufliegt.

12. Verwendung einer Durchtrennungsvorrichtung nach Anspruch 11,
**dadurch gekennzeichnet,**
**daß** die Gleitfläche (41) des Schneidwerkzeugs eine erste und einer zweite Schneidkante (42, 44) für eine erste und eine zweite Vorschubrichtung des Schneidwerkzeugs (30) vorsieht.

13. Verwendung einer Durchtrennungsvorrichtung nach Anspruch 12,
**dadurch gekennzeichnet,**
**daß** die Gleitfläche (41) rechteckig ist mit vorzugsweise kleinerer erster Schneidkante (42) für die erste Vorschubrichtung als Hauptritzrichtung und längerer zweiter Schneidkante (44) für die zweite Vorschubrichtung als Verschiebungsrichtung.

14. Verwendung einer Durchtrennungsvorrichtung nach Anspruch 13,
**dadurch gekennzeichnet,**
**daß** der pyramidenstumpfartigen Form eine vierseitige, gerade Pyramide zugrunde liegt und daß die sich von der ersten und zweiten Schneidkante (42, 44) erstreckenden Seitenflächen des Pyramidenstumpfes, die die Spanflächen (46, 48) des Schneidwerkzeugs (30) bilden, unterschiedlich große Öffnungswinkel (α, β) mit einem kleineren Winkel (α) für die Hauptritzrichtung und einem größeren Winkel (β) für die Verschiebungsrichtung aufweisen.

15. Verwendung einer Durchtrennungsvorrichtung nach einem der Ansprüche 11 bis 14,
**dadurch gekennzeichnet,**
**daß** das stichelförmige Schneidwerkzeug (30) aus Hartmetall besteht.

## Claims

1. Method for manufacturing a CdS/CdTe thin film solar module (10) having a plurality of CdS/CdTe solar cells (11) arranged beside one another on a common substrate (12), which are produced and connected together by using a plurality of coating steps and layer separating steps during the cell manufacture, in which, following the application of a first contact layer (14) to the substrate (12) and its division cell by cell, a double pn layer (16) of CdS/CdTe applied to the cut contact layer is severed mechanically, **characterized in that** the severing is carried out with a scriber-like cutting tool (30) which, as a result of a relative movement in relation to the coated substrate, slits the cell structure into the double pn layer and, in the process, slides with a flattened tip (40) on the first contact layer (14), which has a higher hardness than the double pn layer (16), the cutting tool (30) being guided in such a way that the sliding surface (41) created by the flattening rests with its entire area on the first contact layer (14) parallel to it.

2. Method according to Claim 1, **characterized in that** a pressing force exerted on the cutting tool (30) is increased with an abrasion-induced increase in the area of the flattened surface.

3. Method according to Claim 1 or 2, **characterized in that** the cutting tool (30) is moved in different directions relative to the coated substrate (12) without being rotated and preferably also without being lifted, in order to reach new starting positions and to carry out severing operations in different directions.

4. Method according to one of Claims 1 to 3, **characterized in that**, following the application of a second contact layer (18) to the double CdS/CdTe pn layer (16), this second contact layer is likewise severed by means of the scriber-like cutting tool (30), together with the double pn layer (16) lying underneath, the flattened cutting tool tip (40) sliding on the first contact layer (14).

5. Method according to one of the preceding claims, **characterized in that** the double pn layer (16) is severed by a first cutting edge (42) of the cutting tool (30) in a first feed direction, and **in that** the cutting tool is pushed further on the substrate in a second feed direction.

6. Method according to Claim 5, **characterized in that** a cell group comprising a plurality of cells (11) arranged beside one another is slit synchronously by a plurality of cutting tools (30) guided jointly in the first feed direction, which are then pushed onwards to a not yet slit cell group in the second feed direction, preferably at right angles to the first feed direction.

7. Method according to Claim 5 or 6, **characterized in that** the relative movement in the first feed direction is brought about by moving the cutting tool (30) and in the second feed direction by moving the substrate (10).

8. Method according to one of the preceding claims, **characterized in that** the cutting tool (30) is pressed with its flattened tip (40) in a sprung manner against the coated substrate surface.

9. Method according to one of the preceding claims, **characterized in that** the cutting tool (30) is used with an initially minimum permissible width of its cutting edge (42) until, as a result of an abrasion-induced increase in the width, a maximum permissible width is reached.

10. Method according to one of the preceding claims, **characterized in that** in the case of a double CdS/CdTe pn layer in which the CdS layer has a thickness in the region of only 100 nm or less, the flattened tip (14) of the cutting tool (30) slides on the first contact layer coated with the thin CdS layer instead of on the first contact layer (14).

11. Use of a severing apparatus for manufacturing a CdS/CdTe thin film solar module (10) having a plurality of CdS/CdTe solar cells (11) arranged beside one another on a common substrate (12), which are produced and connected together by using a plurality of coating steps and layer separating steps with the severing apparatus during the cell manufacture, **characterized by** at least one scriber-like cutting tool (30) with a flattened tip (40), whose flattening has a flat sliding surface of the scriber-like tool, preferably in a form in the manner of an inverted truncated pyramid whose small base surface (41) forms this sliding surface, with which sliding surface the cutting tool (30), during a relative movement in relation to the coated substrate, while simultaneously slitting a cell structure into the double CdS/CdTe pn layer of the thin film solar module, slides on a hard contact layer (14) which lies under the double layer and has a higher hardness than the double pn layer (16), the cutting tool (30) being guided in a holding device (50) of the severing device such that the flat sliding surface (41) rests with its entire area on the hard contact layer (14) parallel to it.

12. Use of a severing apparatus according to Claim 11, **characterized in that** the sliding surface (41) of the cutting tool provides a first and a second cutting edge (42, 44) for a first and a second feed direction of the cutting tool (30).

13. Use of a severing apparatus according to Claim 12, **characterized in that** the sliding surface (41) is rectangular with a preferably smaller first cutting edge (42) for the first feed direction as a main slitting direction, and a longer second cutting edge (44) for the second feed direction as a displacement direction.

14. Use of a severing apparatus according to Claim 13, **characterized in that** the truncated pyramidal form is based on a four-sided right pyramid, and **in that** the side surfaces of the truncated pyramid which extend from the first and second cutting edge (42, 44) and which form the material-removing surfaces (46, 48) of the cutting tool (30) have opening angles (α, β) of different sizes with a smaller angle (α) for the main slitting direction and a larger angle (β) for the displacement direction.

15. Use of a severing apparatus according to one of Claims 11 to 14, **characterized in that** the scriber-like cutting tool (30) consists of hard metal.

## Revendications

1. Procédé de fabrication d'un module solaire à couche mince de CdS/CdTe (10) avec plusieurs cellules solaires CdS/CdTe (11) disposées les unes à côté des autres sur un substrat commun (12), qui sont produites et couplées par réalisation de plusieurs étapes de revêtement et d'étapes de séparation de couche pendant la fabrication des cellules, où après application d'une première couche de contact (14) sur le substrat (12) et sa séparation en cellules, une couche pn double (16), en CdS/CdTe appliquée sur la couche de contact séparée, est mécaniquement séparée, **caractérisé en ce que** la séparation est réalisée avec un outil de coupe (30) en forme de burin, qui entaille la structure de cellule dans la couche pn double par un mouvement relatif par rapport au substrat revêtu et ainsi, glisse avec une pointe aplatie (40), sur la première couche de contact (14) qui présente une dureté plus élevée que la couche pn double (16), où l'outil de coupe (30) est conduit de sorte que la surface de glissement (41) formée par l'aplatissement repose sur toute sa surface sur la première couche de contact (14) qui lui est parallèle.

2. Procédé selon la revendication 1, **caractérisé en ce qu'**une force de pression exercée sur l'outil de coupe (30) est amplifiée avec l'augmentation de surface induite par l'usure de la surface aplatie.

3. Procédé selon la revendication 1 ou 2, **caractérisé en ce que** l'outil de coupe (30) procède en différentes directions par rapport au substrat revêtu (12), sans être tourné et de préférence, sans être levé, pour atteindre de nouvelles positions de départ et réaliser les séparations en différentes directions.

4. Procédé selon l'une des revendications 1 à 3, **caractérisé en ce qu'**après application d'une deuxième couche de contact (18) sur la couche pn double en CdS/CdTe (16), cette deuxième couche de contact est également séparée à l'aide de l'outil de coupe (30) en forme de burin, avec la couche pn double sous-jacente (16), où la pointe aplatie (40) de l'outil de coupe glisse sur la première couche de contact (14).

5. Procédé selon l'une des revendications précédentes, **caractérisé en ce que** la couche pn double (16) est séparée avec un premier bord de coupe (42) de l'outil de coupe (30) dans une première direction d'avance et **en ce que** l'outil de coupe est déplacé sur le substrat selon une deuxième direction d'avance.

6. Procédé selon la revendication 5, **caractérisé en ce qu'**un groupe de cellules, comprenant plusieurs cellules (11) voisines, est entaillé de manière synchrone par plusieurs outils de coupe (30) conduits de manière commune dans une première direction d'avance, lesquels sont déplacés ensuite vers un deuxième groupe de cellules, non encore entaillé, dans une deuxième direction d'avance, de préférence perpendiculairement à la première direction d'avance.

7. Procédé selon la revendication 5 ou 6, **caractérisé en ce que** le mouvement relatif agit dans la première direction d'avance par déplacement de l'outil de coupe (30) et dans la deuxième direction d'avance, par déplacement du substrat (10).

8. Procédé selon l'une des revendications précédentes, **caractérisé en ce que** l'outil de coupe (30) est pressé de manière élastique, avec sa pointe aplatie (40) contre la surface du substrat revêtu.

9. Procédé selon l'une des revendications précédentes, **caractérisé en ce que** l'outil de coupe (30) est mis en oeuvre avec une largeur de départ, minimale admissible de son bord de coupe (42), jusqu'à ce que l'augmentation de la largeur, conditionnée par l'usure, atteigne une largeur maximale admissible.

10. Procédé selon l'une des revendications précédentes, **caractérisé en ce que** pour une couche pn double en CdS/CdTe, où la couche CdS présente une épaisseur située dans l'intervalle de 100 nm ou moins, la point aplatie (40) de l'outil de coupe (30) glisse, non pas sur la première couche de contact (14), mais sur la première couche de contact pourvue de la mince couche en CdS.

11. Utilisation d'un dispositif de séparation pour la préparation d'un module solaire à couche mince de CdS/CdTe (10) avec plusieurs cellules solaires CdS/CdTe (11) disposées les unes à côté des l'autres sur un substrat commun (12), qui sont produites et couplées par réalisation de plusieurs étapes de revêtement et d'étapes de séparation de couche pendant la fabrication des cellules, **caractérisé par** au moins un outil de coupe (30) en forme de burin avec une pointe aplatie (40), dont l'aplatissement a une surface plane de glissement de l'outil en forme de burin, de préférence sous forme d'une pyramide tronquée inversée, dont la plus petite surface de base (41) forme cette surface de glissement, avec laquelle surface de glissement, l'outil de coupe (30) glisse, lors d'un mouvement relatif par rapport au substrat revêtu, avec entaille simultanée d'une structure de cellules dans la couche pn double en CdS/CdTe du module solaire à couche mince sur une couche de contact dure (14) se trouvant sous la couche double, laquelle couche de contact (14) présente une dureté plus élevée que la couche pn double (16), où l'outil de coupe (30) est conduit dans un dispositif support (50) du dispositif de séparation, de sorte que la surface de glissement plane (41) repose sur toute sa surface sur la couche de contact (14) dure qui lui est parallèle.

12. Utilisation d'un dispositif de séparation selon la revendication 11, **caractérisé en ce que** la surface de glissement (41) de l'outil de coupe comprend un premier et un deuxième bord de coupe (42, 44) pour une première et une deuxième directions d'avance de l'outil de coupe (30).

13. Utilisation d'un dispositif de séparation selon la revendication 12, **caractérisé en ce que** la surface de glissement (41) est rectangulaire, avec de préférence un premier bord de coupe plus petit (42) pour la première direction d'avance comme direction principale d'entaille et un deuxième bord de coupe plus long (44) pour la deuxième direction d'avance, comme direction de décalage.

14. Utilisation d'un dispositif de séparation selon la revendication 13, **caractérisé en ce que** la forme de pyramide tronquée repose sur une pyramide droite, à quatre côtés et **en ce que** les surfaces latérales s'étendant à partir des premier et deuxième bords de coupe (42, 44) de la pyramide tronquée, qui forment les surfaces de coupe (46, 48) de l'outil de coupe (30), présentent des angles d'ouverture différents (α, β) avec un angle plus petit (α) pour la direction principale d'entaille et un angle plus grand (β) pour la direction de décalage.

15. Utilisation d'un dispositif de séparation selon une des revendications 11 à 14, **caractérisé en ce que** l'outil de coupe en forme de burin (30) est en métal dur.
